# FASCICULE DE BREVET EUROPEEN

(11) **EP 2 975 634 B1**
(45) Date de publication et mention de la délivrance du brevet: **01.02.2017**
(21) Numéro de dépôt: 15176173.1
(22) Date de dépôt: 09.07.2015
(51) Int. Cl.: H01L 21/311, H01L 21/768, H01L 29/417, H01L 21/3115, H01L 21/02, H01L 21/033, H01L 21/265, H01L 29/66, H01L 29/16, H01L 29/161

(54) **PROCÉDÉ DE FORMATION D'OUVERTURES DE CONTACT POUR UN TRANSISTOR**
VERFAHREN ZUR BILDUNG VON KONTAKTÖFFNUNGEN FÜR EINEN TRANSISTOR
METHOD OF FORMING CONTACT OPENINGS FOR A TRANSISTOR

(30) Priorité: 18.07.2014 FR 1456930
(43) Date de publication de la demande: 20.01.2016
(73) Titulaire: COMMISSARIAT A L'ENERGIE ATOMIQUE ET AUX ENERGIES ALTERNATIVES, 75015 Paris (FR)
(72) Inventeur: POSSEME, Nicolas, 38000 GRENOBLE (FR)
(74) Mandataire: Hautier, Nicolas

(56) Documents cités:
- US-A1- 2002 142 610
- US-A1- 2003 232 504
- US-A1- 2004 067 635
- US-B1- 7 977 249

## Description

### DOMAINE TECHNIQUE DE L'INVENTION

La présente invention concerne en général les transistors à effet de champs (FET) utilisés par l'industrie de la microélectronique et plus particulièrement la réalisation d'ouvertures de contact, le plus souvent des trous de contact, habituellement désignés via, configurés pour la connexion des transistors.

### ÉTAT DE LA TECHNIQUE

Le document US 7977249-B1 divulgue un procédé de réalisation d'ouvertures de contact pour la connexion d'un transistor à effet de champ à partir d'un empilement de couches comprenant au moins une couche active en un matériau semi-conducteur, une couche de siliciure surmontant la couche active, une couche à base de nitrure surmontant la couche de siliciure et une couche isolante électriquement surmontant la couche à base de nitrure. Les documents US 2003/232504-A1 et US 2002/142610-A1 divulguent la formation d'une couche carbonée pour contrôler la forme des trous de contact.

Les procédés de formation des transistors requièrent la formation de trous de contacts configurés pour faciliter la propagation du signal parvenant à la grille et/ou aux source et drain (S/D) du transistor. Un des défis principaux est de former des trous de contact avec une bonne précision de contrôle des emplacements et des dimensions des trous de contacts pour le transistor.

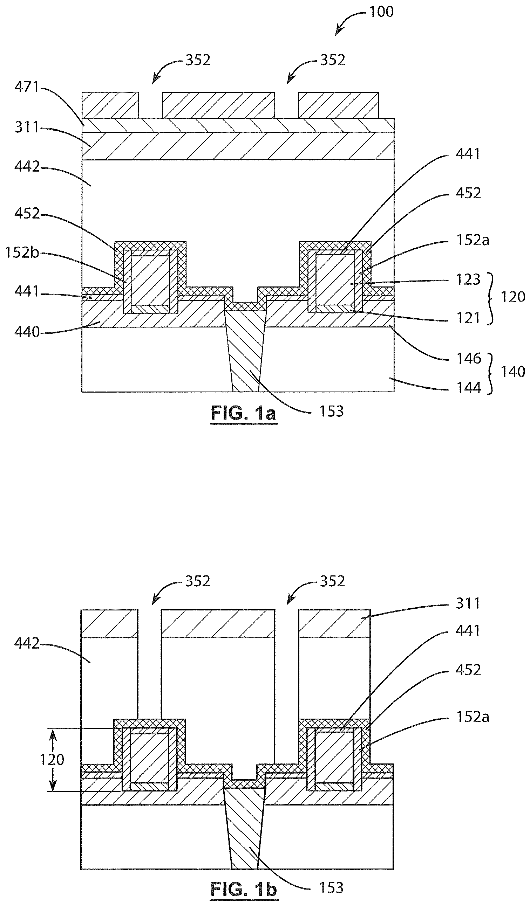

Les **figures 1a à 1f** illustrent la formation des trous de contact pour un transistor 100.

La **figure 1a** est une vue en coupe d'un exemple de transistor 100 en cours de réalisation.

Une technique largement utilisée actuellement consiste à fabriquer les circuits intégrés en partant de substrats élaborés 140 de type silicium sur isolant, désignés par leur acronyme SOI, de l'anglais « silicon on insulator ». Le substrat élaboré SOI est caractérisé par la présence d'une fine couche active 146 de silicium monocristallin reposant sur une couche isolante enterrée 144 d'oxyde de silicium, dit oxyde enterré ou encore BOX, acronyme de l'anglais « buried oxide layer ». La solidité et la rigidité mécanique de l'ensemble sont assurées par la couche (non-illustrée en figures) qui constitue le corps du substrat SOI, souvent qualifié du vocable anglais de « bulk » pour indiquer que le substrat de départ est très généralement fait de silicium massif. Notamment, elle permet une réduction drastique des capacités parasites en raison de la présence de la couche isolante enterrée 144.

Le transistor 100 comprend en outre une grille 120 classiquement constituée d'un empilement de couches dont une grande partie est toujours constituée de silicium polycristallin 123. La grille 120 se situe au dessus de la couche active 146.

En plus de la couche de silicium polycristallin 123, on retrouve dans l'empilement des couches formant la grille 120 tout d'abord une mince couche isolante d'oxyde de grille 121 à travers laquelle un champ électrique va pouvoir se développer pour créer un canal de conduction sous jacent entre source et drain quand une tension électrique suffisante est appliquée sur la grille 120. Dans les transistors MOSFET les plus récents la couche diélectrique 121 est faite d'un matériau isolant à haute permittivité (high-k) couverte par une couche métallique (metal gate non illustrée dans les figures) de la grille 120.

De préférence : la couche diélectrique 121 est disposée au contact de la couche active 146 formant le canal de conduction ; la couche métallique est disposée au contact de la couche diélectrique 121 ; la couche de silicium polycristallin 123 est disposée directement au contact de l'oxyde de grille formée par la couche diélectrique 121 si la couche métallique est absente ou est disposée directement au contact de la couche métallique.

Un perfectionnement de la technique de base d'auto alignement consiste en la formation des espaceurs 152a, 152b sur les flancs de la grille 120. Les espaceurs 152a, 152b, typiquement faits de nitrure et de préférence de nitrure de silicium (SiN).

Un dopage qui va délimiter les source et drain 440 et donc la longueur du canal peut se faire par implantation ionique. Les source et drain 440 sont de préférence de type surélevés et sont formés de préférence par croissance épitaxiale.

Les espaceurs 152a, 152b assurent notamment un rôle de préservation de la grille 120 lors de la siliciuration des contacts (non représentée) qui est ensuite effectuée dans le but de diminuer la résistance série d'accès aux électrodes du transistor 100.

Ces espaceurs peuvent également avoir pour fonction de protéger les zones de grilles pour empêcher la croissance des source et drain 440 à partir du silicium polycristallin 123 de la grille 120.

Le transistor 100 comprend en outre une couche de siliciure 441 de préférence de NiPtSi. Cette couche de siliciure 441 est formée au-dessus des source et drain 440 et de la couche de silicium polycristallin 123. La portion de la couche de siliciure 441 au dessus de la couche de silicium polycristallin 123 fait partie de l'empilement de couches de la grille 120.

Cette couche de silicium 441 est destinée à former une zone de connexion électrique avec d'une part la grille 120, la source ou le drain et un autre élément du circuit. Cette couche présente une très bonne conductivité électrique.

Le transistor 100 comprend également une couche d'arrêt de gravure des contacts (CESL, acronyme de l'anglais « contact etch stop layer ») recouvrant le sommet et les flancs de la grille 120 et la face supérieure de la couche de siliciure 441. Cette couche d'arrêt est typiquement à base de nitrure, de préférence de nitrure de silicium (SiN). Elle est configurée pour protéger l'empilement des couches telles que la couche de siliciure 441 et la grille 120 lors de l'étape de gravure des trous de contacts (illustrée ultérieurement). Par la suite, la couche d'arrêt est également désignée couche à base de nitrure 452.

De plus, la structure telle qu'illustrée en **figure 1a** comprend une tranchée d'isolation de type STI (acronyme de l'anglais « Shallow Trench Isolation » signifiant tranchée d'isolation de faible profondeur ou tranchée d'isolation de surface) formée entre deux transistors 100 adjacents. Par la suite, la tranchée d'isolation 153 est également désignée tranchée STI 153. La tranchée STI 153 est configurée pour empêcher les fuites de courant électrique entre les deux transistors 100 adjacents.

La tranchée STI 153 peut être formée de manière conventionnelle, telle que par gravure pour former une cavité dans les couches formant le substrat 140, et subséquemment par un remplissage de la cavité par dépôt d'oxyde et un polissage mécano-chimique (CMP, acronyme de l'anglais « Chemical Mechanical Polishing », par exemple).

Le transistor 100 comprend en outre des couches telles qu'une couche isolante 442, un masque dur 311 et une couche anti-réflective 471 (de l'anglais « Anti Reflecting Coating »). Ces trois couches 442, 311, 471 sont réalisées de manière conventionnelle.

La couche isolante 442, surmontant la couche à base de nitrure 452, est de préférence de l'oxyde de silicium (SiO2).

La masque dur 311 recouvrant la couche isolante 442 est habituellement réalisée en un matériau de carbone de type « Spin-On Carbon » (abréviation « SOC »). Ce masque dur 311 est configuré pour protéger la couche d'oxyde 442 et la structure recouverte par cette dernière lors d'une étape de lithographie des contacts.

La couche anti-réflective 471, formée au dessus du masque dur 311, est par exemple une couche de type « SiARC ».

Une couche résine est également formée au-dessus du masque dur 311 et de la couche anti-réflective 471 pour réaliser dans cette dernière les motifs des ouvertures par des opérations classiques de lithographie, par exemple de photolithographie, comme illustré en **figure 1a****.**

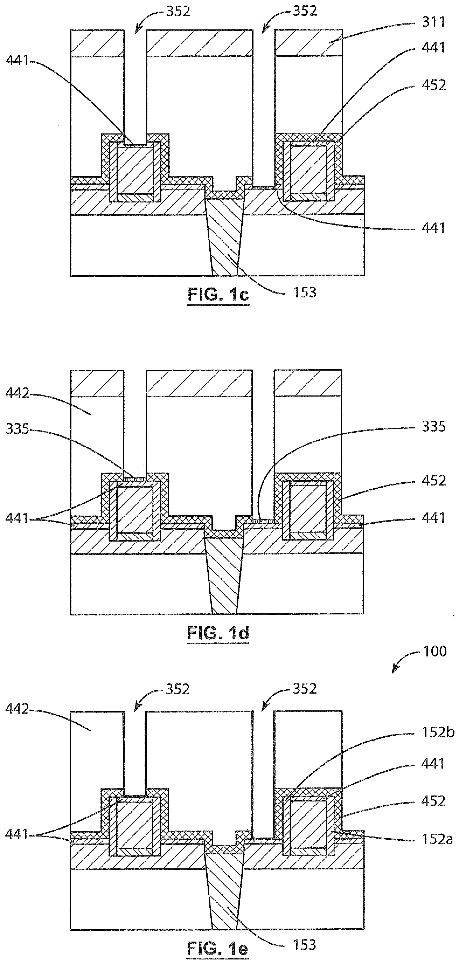

Afin de former des ouvertures 352, typiquement des trous ou tranchées, pour le transistor 100, comme illustré en **figure 1e****,** les procédés connus comprennent la gravure de la couche isolante 442 d'oxyde de silicium, avec arrêt sur la couche à base de nitrure 452 puis la gravure de la couche à base de nitrure, puis le retrait du masque dur 311 en utilisant une chimie oxydante.

La **figure 1b** montre une structure obtenue à l'issue d'étape de formation des ouvertures 352, ici, deux ouvertures, dans la couche isolante 442.

L'ouverture 352 est réalisée de manière à graver toute l'épaisseur du masque dur 311 et de celle de la couche isolante 442 respectivement situées au droit des motifs formés dans la couche anti-réflective 471. L'ouverture 352 est délimitée, dans un plan parallèle à celui dans lequel s'étendent les différentes couches, par des flancs de la couche isolante 442.

De manière conventionnelle, on procède ensuite au retrait de la couche à base de nitrure 452 située au droit des ouvertures 352, de manière à mettre à nu la couche de siliciure 441, ceci afin de permettre une connexion ultérieure de la grille 120 ou des S/D 440 par l'interface formée par la couche de siliciure 441. Cette gravure de la couche à base de nitrure 452 est, de manière connue, réalisée par un plasma formé d'une chimie fluorocarbonée (FC).

La gravure s'arrête sur la couche à base de nitrure 452. La surface de la couche à base de nitrure 452 au fond de l'ouverture 352 est donc mise à nu.

La gravure est réalisée par l'utilisation un chimique fluorocarbonée, de préférence de type CF4 ou de type C4F8.

Néanmoins, le retrait de la couche à base de nitrure 452 (en chimie fluorocarbonée) et/ou le retrait du masque dur 311 (en chimie oxydante) selon les solutions connues, conduisent à une modification involontaire de la couche sous-jacente de siliciure 441. Cette modification entraine en pratique une augmentation de la résistance de cette couche 452 et donc une augmentation du temps de propagation du signal parvenant à la grille 120 et/ou aux source et drain 440.

En effet, dans le cadre de la présente invention, et comme cela sera détaillé par la suite, il a été constaté que plusieurs types de défaut surviennent dans la couche de siliciure 441, comme illustré en figures **1c** et **1d****.**

Un premier défaut concerne la modification de la composition de la couche de siliciure 441. La composition de cette couche de siliciure 441 se modifie en effet sous l'impact des ions du plasma.

Cette détérioration conduit à une réduction de la vitesse de propagation du signal par la couche de siliciure 441.

Par ailleurs, la **figure 1c** montre une consommation excessive et involontaire de la couche de siliciure 441 lors d'un retrait d'une portion de la couche à base de nitrure 452 au droit de l'ouverture 352, par utilisation un plasma de type fluorocarbonée. Cela provient du fait qu'en gravant la couche à base de nitrure 452, le bombardement ionique du plasma détériore la couche de siliciure 441 sous-jacente. Dans la structure alors obtenue, l'épaisseur de la portion de la couche de siliciure 441 située au fond de l'ouverture 352 est inférieure à celle de la portion de la couche de siliciure 441 située en dehors de la zone au droit de l'ouverture 352, comme illustré en **figure 1c****.**

La **figure 1d** montre un autre problème où des cristaux 335 sont formés au fond de l'ouverture 352. Dans le cadre du développement de la présente invention, il a été remarqué qu'en utilisant un plasma à base d'une chimie fluorocarbonée, il se crée une réaction chimique entre le siliciure, l'air ambiant et le fluor du plasma utilisé. Cette réaction forme des cristaux 335 à la surface supérieure de la couche de siliciure 441 au fond de l'ouverture 352. Ces cristaux 335 forment un résidu en fond de l'ouverture 352. Les cristaux 335 augmentent la résistivité de la couche de siliciure 441 et participent ainsi également à la baisse de performance du transistor 100.

La **figure 1e** montre une structure finale obtenue à l'issue d'une étape de retrait du masque dur 311. A cette étape, le masque dur 311 est gravé en utilisant une chimie oxydante, par exemple de type N2/O2.

La **figure 1e** montre une situation idéale sans défaut formé sur la couche de siliciure 441 tel que décrit précédemment et illustré en **figure 1c** et **1d****.**

Les problèmes décrits ci-dessus et illustrés en figures **1c** et **1d** conduisent à réduire les performances du transistor 100.

Ainsi, la présente invention a pour objet de proposer une solution pour augmenter les performances des transistors.

Pour résoudre cette problématique, l'invention propose un procédé de formation d'ouvertures de contact du transistor qui limite voire empêche la dégradation de la couche de siliciure et empêche la formation des résidus, afin de conserver la haute conductivité de la couche de siliciure de manière à réduire le temps de propagation du signal parvenant à la grille.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, un aspect de la présente invention concerne un procédé de réalisation d'ouvertures de contact pour la connexion d'un transistor à effet de champ à partir d'un empilement de couches comprenant au moins une couche active en un matériau semi-conducteur, une couche de siliciure continue ou non surmontant la couche active, une couche à base de nitrure surmontant la couche de siliciure et une couche isolante électriquement surmontant la couche à base de nitrure, le procédé comprenant les étapes suivantes : une étape d'ouverture de la couche isolante pour former au moins dans la couche isolante une ouverture mettant à nu sur la couche à base de nitrure et délimitée par des flancs de la couche isolante, et une étape de retrait de la couche à base de nitrure au droit de l'ouverture de manière à mettre à nu la couche de siliciure.

Selon le procédé de l'invention, l'étape de retrait de la couche à base de nitrure au droit de l'ouverture comprend les étapes suivantes : ,
- au moins une étape de modification de la couche à base de nitrure au droit de l'ouverture par mise en présence de la couche à base de nitrure avec un plasma dans lequel on introduit du CxHy où x est la proportion de carbone et y est la proportion d'ions à base d'hydrogène. Le plasma comprend au moins des ions à base d'hydrogène (H, H⁺, H₂⁺, H₃⁺ etc.) provenant notamment du CxHy, des espèces chimiques contenant du carbone provenant du CxHy et des ions plus lourds que l'hydrogène. Les conditions du plasma, en particulier la concentration en CxHy, l'énergie des ions et la direction principale d'implantation sont choisies de manière à ce que :
   o des ions à base d'hydrogène provenant du CxHy s'implantent dans une portion de la couche à base de nitrure au droit de l'ouverture de manière à former une portion modifiée de la couche à base de nitrure;
   o des espèces chimiques du plasma contenant du carbone provenant du CxHy forment un film carboné sur lesdits flancs de la couche isolante.
   o les ions plus lourds que l'hydrogène empêchent au carbone du CxHy de former un film carboné sur le fond de l'ouverture.
- au moins une étape de retrait de la portion modifiée à base de nitrure à l'aide d'une gravure sélective de la portion modifiée à base de nitrure vis-à-vis des portions non-modifiées de la couche à base de nitrure et vis-à-vis au film carboné.

Plus précisément, le bombardement ionique des ions plus lourds que l'hydrogène pulvérise le dépôt des espèces chimiques du plasma contenant du carbone provenant du CxHy sur le fond des motifs et évite ainsi la formation d'un film carboné sur le fond de l'ouverture.

Préférentiellement, les ions plus lourds que l'hydrogène sont pris parmi l'hélium (H), l'Argon (Ar), l'azote (N2), le xénon (Xe) et l'oxygène (02).

L'ouverture obtenue à l'issue de la réalisation du procédé est le trou de contact pour former un via pour le transistor.

Ainsi, l'invention ne modifie pas la couche de siliciure sous-jacente. Par ailleurs, la gravure comprenant de l'acide fluorhydrique ne réagit pas ou que peu avec la couche de siliciure et évite ainsi la formation de résidus peu conducteurs dans le fond de l'ouverture. Par ailleurs, le film carboné provenant du CxHy du plasma permet le dépôt d'une couche de passivation sur les flancs des structures qui protège les flancs de la couche isolante lors de l'étape de retrait de la portion modifiée.

L'invention permet ainsi de former des trous de contact de manière reproductible tout en améliorant la vitesse de propagation du signal au niveau du siliciure.

De manière avantageuse et optionnelle, l'invention présente les caractéristiques suivantes.

L'étape de modification est réalisée de manière à ce que le plasma crée le bombardement d'ions à base d'hydrogène de manière anisotrope selon une direction privilégiée parallèle aux flancs de la couche isolante définissant l'ouverture, et de sorte à modifier uniquement la portion de la couche à base de nitrure au droit de l'ouverture en conservant des portions non-modifiées de la couche à base de nitrure en dehors de la zone au droit de l'ouverture.

Les ions à base d'hydrogène sont de préférence pris parmi : H, H+, H2+, H3+.

Un film carboné est un film comprenant des espèces chimiques contenant du carbone. Selon un mode de réalisation non limitatif le film carboné est en carboné.

L'étape de modification est réalisée de manière à former un film de carbone notamment sur des surfaces parallèles à la direction du bombardement et tout en empêchant aux espèces chimiques du plasma contenant du carbone provenant du CxHy de former un film carboné sur le fond de l'ouverture.

De manière particulièrement avantageuse, il a été constaté que le bombardement d'ions plus lourds que l'hydrogène (désignés par la suite « ions lourds ») permet aux espèces chimiques du plasma contenant du carbone provenant du CxHy de former un film protecteur carboné notamment sur des surfaces parallèles à la direction du bombardement et empêche par ailleurs à ces espèces chimiques contenant du carbone de former un film carboné sur les flancs de la couche isolante qui sont perpendiculaires à la direction du bombardement.

Le bombardement d'ions lourds détruit en effet le film carboné qui aurait tendance à se déposer sur les surfaces perpendiculaires à la direction du bombardement, typiquement sur la couche à base de nitrure située au droit de l'ouverture.

La gravure est sélective de la portion modifiée de nitrure vis-à-vis dudit film carboné, ce film carboné permettant ainsi de protéger de la gravure les surfaces parallèles à la direction de bombardement. Le film carboné fait alors office de film de protection qui empêche la modification ou/et la dégradation de la couche isolante recouverte et protégée par le film carboné.

De manière particulièrement avantageuse, la modification de la portion de la couche à base de nitrure par implantation d'ions à base d'hydrogène permet d'améliorer considérablement la sélectivité de cette couche à base de nitrure par rapport au film carboné et au siliciure de la couche de siliciure, typiquement de NiPtSi. La sélectivité permet aussi de modifier la portion de la couche à base de nitrure au droit de l'ouverture en conservant le reste de la couche à base de nitrure situé en dehors de la zone au droit de l'ouverture.

Cette implantation fait également que l'épaisseur de nitrure modifiée se grave plus rapidement que le nitrure non modifiée. La gravure consomme ainsi la portion modifiée située au droit de l'ouverture préférentiellement à la couche à base de nitrure non modifiée, au film carboné et à la couche de siliciure. Ainsi, le risque de consommation excessive de la couche de siliciure est réduit voire supprimé.

L'invention permet ainsi d'obtenir des trous de contact tout en réduisant voire en éliminant les problèmes des solutions connues et mentionnés précédemment.

Selon un mode de réalisation particulièrement avantageux, l'implantation est réalisée à partir d'un plasma comprenant lesdits ions à base d'hydrogène.

En outre l'utilisation d'un plasma permet une implantation à des profondeurs plus faibles que les profondeurs minimales que l'on peut obtenir avec des implanteurs. Ainsi, une implantation par plasma permet d'implanter efficacement et de manière relativement homogène ou tout au moins de manière continue des épaisseurs fines que l'on peut ensuite retirer par une gravure sélective. Cette continuité d'implantation depuis la face implantée permet d'améliorer l'homogénéité de la modification selon la profondeur, ce qui conduit à une vitesse de gravure constante dans le temps de la couche implantée. Par ailleurs, l'augmentation de la sélectivité conférée par l'implantation vis à vis des autres couches est effective dès le début de la gravure de la couche implantée. L'implantation par plasma permet ainsi un contrôle significativement amélioré de la précision de gravure pour des couches de faible épaisseur telle qu'une couche à base de nitrure.

L'implantation plasma permet typiquement d'implanter puis de retirer des épaisseurs s'étendant depuis la surface de la couche implantée et sur une profondeur allant de 0 nm à 100 nm. Les implanteurs classiques, permettent une implantation dans un volume compris entre 30 nm et plusieurs centaines de nanomètres. En revanche, les implanteurs classiques ne permettent pas d'implanter les espèces entre la surface de la couche à implanter et une profondeur de 30 nm. Dans le cadre du développement de la présente invention, il a été remarqué que les implanteurs ne permettent alors pas d'obtenir une vitesse de gravure suffisamment constante de la portion modifiée et ce depuis la surface de cette dernière, conduisant ainsi à une moindre précision de gravure comparé à ce que permet l'invention.

L'utilisation d'un plasma pour modifier la portion à retirer est donc particulièrement avantageuse dans le cadre de l'invention qui vise à retirer une fine épaisseur de nitrure, typiquement comprise entre 1 et 10 nm et plus généralement entre 1 et 30 nm.

L'étape de modification réalisée à partir d'un plasma modifie la couche à base de nitrure de manière continue depuis la surface de la couche à base de nitrure et sur une épaisseur comprise entre 1 nm et 30 nm et de préférence entre 1 nm et 10 nm.

Sont énoncées ci-après des caractéristiques optionnelles qui peuvent éventuellement être utilisées en association ou alternativement avec les caractéristiques ci-dessus:
Le bombardement des ions lourds, en particulier son énergie, sa direction et sa fluence sont prévues de sorte que le film carboné se forme sur les surfaces parallèles à la direction d'implantation et de sorte que le film carboné ne se forme pas sur les surfaces de la couche à base de nitrure qui sont perpendiculaires à la direction d'implantation.

Le film carboné agit comme un film de protection pour la couche isolante empêchant ou réduisant la modification de cette dernière sous l'effet du bombardement ionique. Le film carboné n'est ainsi pas ou que peu modifiée lors de l'étape de modification.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les FIGURES 1a à 1e montrent, d'une part, une vue en coupe d'un exemple de formation de trous de contact pour un transistor en cours de réalisation et, d'autre part, illustrent différents défauts qui peuvent être observés sur des structures de transistors lors de la modification ou/et de gravure d'une couche à base de nitrure en utilisant un procédé standard de gravure de type fluorocarbonée.
Les FIGURES 2a à 2c et 2f illustrent respectivement une structure obtenue à l'issue d'une des étapes d'un procédé réalisé pour former des trous de contact selon un premier mode de réalisation de l'invention.
Les FIGURES 2a, 2b, 2d et 2e illustrent respectivement une structure obtenue à l'issue d'une des étapes d'un procédé selon un deuxième mode de réalisation de l'invention.
La FIGURE 3 résume les principales étapes d'un exemple de procédé selon l'invention.
La FIGURE 4 montre les étapes du retrait par voie sèche de la portion modifiée située au droit de l'ouverture.

Les dessins joints sont donnés à titre d'exemples et ne sont pas limitatifs de l'invention. Ces dessins sont des représentations schématiques et ne sont pas nécessairement à l'échelle de l'application pratique. En particulier, les épaisseurs relatives des couches et des substrats ne sont pas représentatives de la réalité.

### DESCRIPTION DÉTAILLÉE DE L'INVENTION

Il est précisé que dans le cadre de la présente invention, le terme « sur », « surmonte », « recouvrir » ou « sous jacent » ou leurs équivalents ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Dans la description qui suit, les épaisseurs sont généralement mesurées selon des directions perpendiculaires au plan de la face inférieure de la couche à graver ou d'un substrat sur lequel la couche inférieure est disposée. Ainsi, les épaisseurs sont généralement prises selon une direction verticale sur les figures représentées. En revanche l'épaisseur d'une couche recouvrant un flanc d'un motif est prise selon une direction perpendiculaire à ce flanc.

Avant d'entamer une revue détaillée de modes de réalisation de l'invention, sont énoncées ci-après des caractéristiques optionnelles qui peuvent éventuellement être utilisées en association ou alternativement :
De manière avantageuse, le CxHy est du CH4.

Les ions plus lourds que l'hydrogène du plasma, sont pris parmi l'argon (Ar), l'hélium (He), l'azote (N2), le xénon (Xe) et l'oxygène (02). Ils peuvent être utilisés alternativement ou être combinés dans un même plasma. Leur rôle est d'empêcher la formation du film carboné dans le fond du motif. D'autres ions peuvent convenir.

Les ions à base d'hydrogène sont pris parmi : H, H⁺, H2+, H3+.

La couche à base de nitrure est préférentiellement une couche de nitrure de silicium.

La couche de siliciure est une couche de NiPtSi.

La couche isolante est de l'oxyde de silicium.

L'étape de retrait de la portion modifiée à base de nitrure au droit de l'ouverture, est de préférence effectuée par gravure humide sélective aux espèces chimiques contenant du carbone et formant le film carboné, aux portions non modifiées de la couche à base de nitrure, et au siliciure de la couche de siliciure. Dans ce cas, la portion modifiée est consommée très facilement par rapport à la consommation du nitrure non modifié, du film carboné, et du siliciure de la couche de siliciure.

En effet, l'invention prévoit une solution de gravure à base d'acide fluorhydrique (HF) qui consomme le nitrure à une vitesse de 0.5 nm/minute et avec une sélectivité du nitrure par rapport au silicium de l'ordre supérieure à 100. En effet, le silicium ne se grave pas en acide HF.

De plus, la sélectivité du nitrure modifié par rapport au film carboné et au nitrure non modifié est respectivement supérieure à 100 et à 30 respectivement. Cela permet donc d'améliorer considérablement la sélectivité et donc la précision de la gravure. On évite ainsi de consommer de manière excessive la couche de siliciure et la couche isolante.

La résistance de la couche isolante du transistor selon l'invention est particulièrement faible, ce qui permet d'améliorer les performances du transistor. De plus, la vitesse de propagation du signal au niveau du siliciure est augmentée.

D'autres caractéristiques optionnelles de l'invention, qui peuvent être mises en oeuvre de façon combinée selon toutes combinaisons ou de manière alternative, sont indiquées ci-après :
- Avantageusement, l'étape de modification est réalisée de manière à ce que les ions plus lourds que l'hydrogène du plasma dissocient la molécule du CxHy de sorte à permettre aux ions à base d'hydrogène (H) provenant du CxHy de s'implanter dans ladite portion de la couche à base de nitrure. Il s'est avéré de l'hélium (He) est particulièrement efficace pour obtenir cette dissociation du CxHy.
- Les conditions du plasma, en particulier la concentration en CxHy, l'énergie des ions et la direction principale d'implantation sont choisies de manière à ce que toute l'épaisseur de la couche à base de nitrure soit modifiée par implantation des ions H. Ainsi, lors de l'étape de retrait de la couche modifiée, la gravure met à nu la couche de siliciure au droit des ouvertures.
- Selon un mode de réalisation, l'étape de retrait de la portion modifiée est effectuée par gravure sèche sélective de ladite portion modifiée de nitrure vis-à-vis dudit film carboné, vis-à-vis des portions non-modifiées de la couche à base de nitrure, et vis-à-vis du siliciure de la couche de siliciure.
- L'empilement de couches comprend en outre un masque dur surmontant la couche isolante.
- Le masque dur est fait d'un matériau de carbone, de préférence de type « Spin-On Carbon ».
- Préférentiellement, la gravure sèche est effectuée dans un plasma formé dans une enceinte confinée à partir de trifluorure d'azote (NF3) et d'ammoniaque (NH3).
- Avantageusement, la gravure sèche comprend une étape de gravure consistant en la formation de sels solides ; et une étape de sublimation des espèces solides. Ce mode de réalisation permet d'obtenir une très bonne sélectivité de la gravure du nitrure modifié par rapport au nitrure non modifié, au carbone et au siliciure. En particulier, cette sélectivité de la gravure est très supérieure (typiquement un facteur 10 au moins) à celle obtenue avec une solution de HF.
- Le matériau semi-conducteur est pris parmi: le silicium (Si), le germanium (Ge), le silicium-germanium (SiGe).
- L'étape de modification réalisée à partir d'un plasma modifie la couche à base de nitrure de manière continue depuis la surface de la couche à base de nitrure et sur une épaisseur comprise entre 1 nm et 30 nm et de préférence entre 1 nm et 10 nm.
- Le procédé comprend en outre une étape de retrait du masque dur qui est effectuée, après l'étape de retrait de la portion modifiée à base de nitrure, par une gravure sélective du masque dur vis-à-vis de la couche isolante et de la couche de siliciure.
- La gravure utilisée lors de l'étape de retrait du masque dur retire également le film carboné.
- La gravure est réalisée dans un plasma avec une chimie oxydante de type N2/O2.
- Alternativement, le procédé comprend en outre une étape de retrait du masque dur qui est effectuée, après l'étape de modification de la couche à base de nitrure et avant l'étape de retrait de la portion modifiée, par une gravure sélective du masque dur vis-à-vis du film carboné recouvrant lesdits flancs de la couche isolante, de la portion modifiée à base de nitrure et optionnellement vis-à-vis également de la couche à base de nitrure et de la couche de siliciure.
- La gravure est réalisée dans un plasma avec une chimie oxydante de type N2/H2.
- La couche de siliciure est continue ou discontinue de manière à former des motifs. Elle recouvre par exemple le sommet de la grille et la couche active là où cette dernière n'est pas surmontée par la grille.
- Le transistor est un transistor de type FDSOI ou FinFET. Ainsi dans un mode de réalisation, la portion modifiée à base de nitrure est conservée lors de la gravure du masque dur. La portion modifiée à base de nitrure protège ainsi la couche de siliciure lors de la gravure du masque dur.
- L'ouverture débouche sur la couche de siliciure au niveau de l'un parmi : une grille, une source, un drain du transistor, de manière à former un via d'interconnexion.

Comme on l'a vu un objet de l'invention est de s'affranchir de tous ou d'au moins certains des problèmes mentionnés ci-dessus.

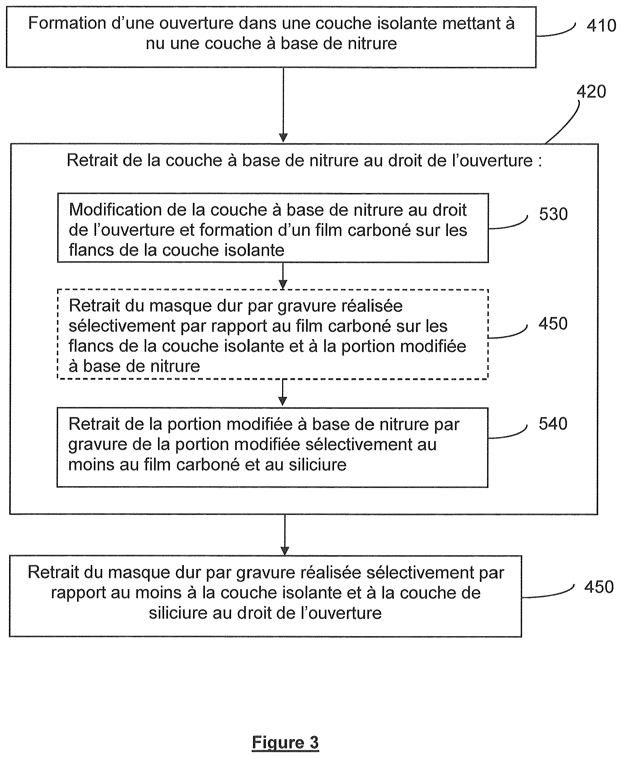

La **figure 3** résume les principales étapes 410 à 450 d'un exemple détaillé d'un procédé de formation d'ouvertures de contact 352 pour un transistor 200 selon l'invention. Une extrémité de l'ouverture de contact 352 connecte au moins l'un parmi une grille, une source, un drain du transistor 200.

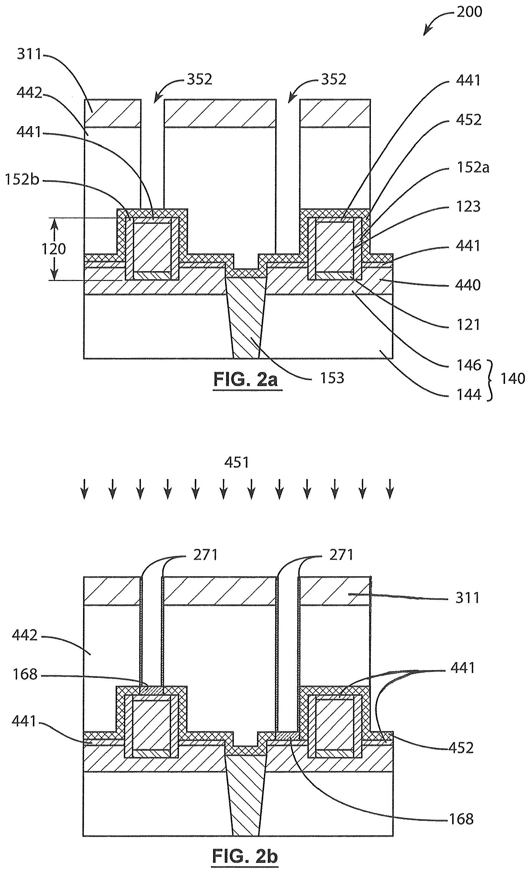

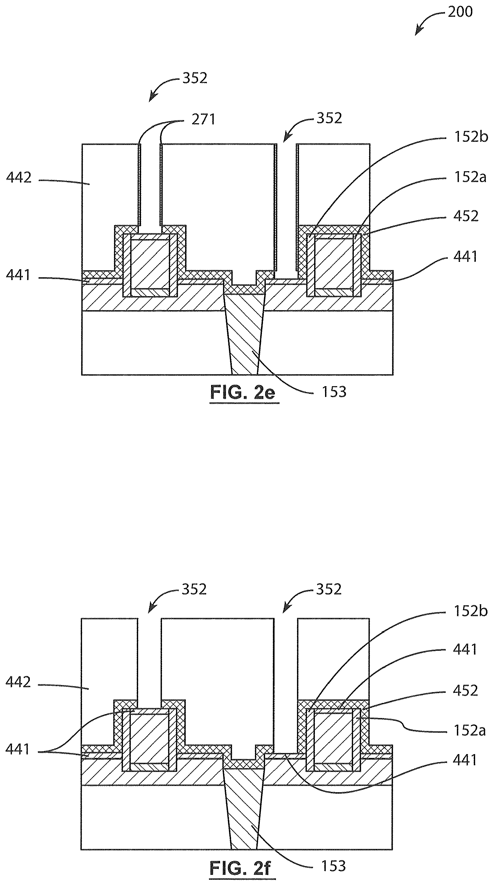

Les étapes 410 à 450 seront respectivement détaillées dans les paragraphes suivants concernant les **figures 2a** à **2c** et **2f** illustrant respectivement une structure d'un transistor 200 obtenue à l'issue d'une des étapes 410 à 450.

Le transistor 200 peut être similaire, au niveau de sa structure, au transistor 100 comme illustré en **figure 1b**. Par exemple, la structure du transistor 200 est formée à partir d'un empilement de couches comprenant au moins une couche active 146 en un matériau semi-conducteur, une couche de siliciure 441 surmontant la couche active 146, une couche à base de nitrure 452 surmontant la couche de siliciure 441 et une couche isolante 442 électriquement surmontant la couche à base de nitrure 452. Le matériau semi-conducteur de la couche active 146 est pris parmi: le silicium (Si), le germanium (Ge), le silicium germanium (SiGe). La couche de siliciure 441 est de préférence de NiPtSi. La couche à base de nitrure 452 est de préférence une couche de nitrure de silicium d'un composé chimique Si3N4 ou SiN. Préférentiellement, la couche isolante 442 est de l'oxyde de silicium tel que le SiO2. De préférence, l'empilement de couches comprend en outre un masque dur 311 surmontant la couche isolante 442. Le masque dur 311 est de préférence faite d'un matériau de carbone de type « Spin-On Carbon » (abréviation « SOC »).

La couche à base de nitrure 452 est préférentiellement d'épaisseur sensiblement uniforme et recouvre le transistor 200 et la tranchée STI 153. Il s'agit ainsi d'un dépôt que l'on peut qualifier de conforme. De manière préférentielle mais non limitative, la couche à base de nitrure 452 est disposée directement au contact des faces supérieures de la couche de siliciure 441, des flancs des espaceurs 152a, 152b du transistor 200 et de la face supérieure de la tranchée STI 153. La couche à base de nitrure 452 peut être formée de manière non différente des procédés connus. La réalisation de la couche à base de nitrure 452 se fait de préférence à l'aide d'une méthode de dépôt dite LPCVD, acronyme de l'anglais « low pressure chemical vapor deposition », c'est-à-dire « dépôt chimique en phase vapeur à faible pression ». Ce type de dépôt qui se pratique à pression atmosphérique permet en effet un dépôt uniforme sur toutes les surfaces quelle que soit leur orientation.

Dans un mode de réalisation préféré, l'épaisseur de la couche à base de nitrure 452 est comprise entre 10 m et 20 nm.

L'invention n'est pas limitée à la réalisation de l'empilement de couches mentionnées ci-dessus.

La **figure 2a** illustre une structure obtenue à l'issue de l'étape d'ouverture 410 de la couche isolante 442.

L'ouverture 352 forme un trou de contact et est destinée à être remplie d'un matériau électriquement conducteur pour la connexion du transistor 200.

Cette étape d'ouverture 410 est similaire à l'étape de formation de la ouverture décrite précédemment et illustrée en **figure 1b**.
L'étape d'ouverture 410 de la couche isolante 442 est réalisée pour former dans la couche isolante 442 l'ouverture 352 avec arrêt sur la couche à base de nitrure 452 et l'ouverture 352 est délimitée par des flancs de la couche isolante 442. La surface de la couche à base de nitrure 452 au fond de l'ouverture 352 est donc mise à nu. L'ouverture 352 forme de préférence un via vertical.
La chimie utilisée pour la gravure est par exemple une chimie fluorocarbonée.

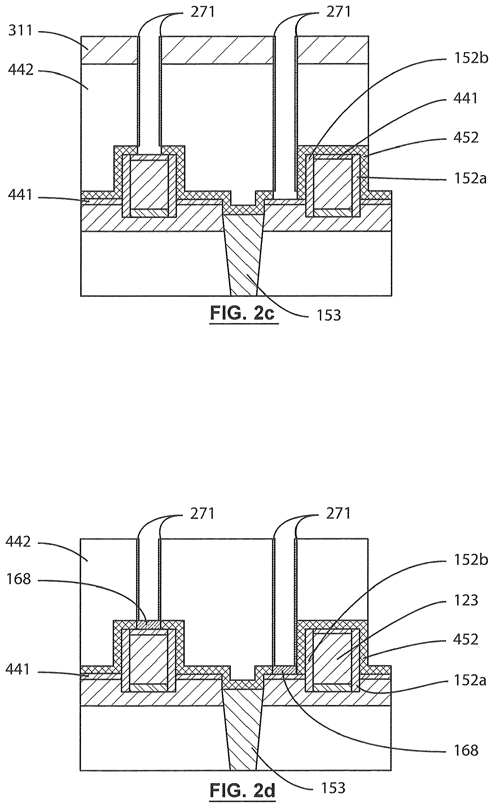

Les **figures 2b** et **2c** montrent les structures obtenues à l'issue de l'étape de retrait 420 de la couche à base de nitrure 452 au droit de l'ouverture 352 selon un mode de réalisation de l'invention. Cette étape de retrait 420 comprend une étape de modification 530 de la couche à base de nitrure 452 au droit de l'ouverture 352, et au moins une étape de retrait 540 de la portion modifiée 168 de la couche à base de nitrure 452.

L'étape de modification 530 de la couche à base de nitrure 452 au droit de l'ouverture 352, se fait par mise en présence de la couche à base de nitrure 452 avec un plasma comprenant du CxHy où x est la proportion de carbone et y est la proportion d'hydrogène, afin d'à la fois modifier une portion 168 de la couche à base de nitrure 452 au droit de l'ouverture 352, et former un film carboné 271 sur les flancs de la couche isolante 442. Le film carboné 271 peut être également formé sur les flancs du masque 311.

L'étape de modification 530 est réalisée de manière à ce que le plasma créé un bombardement d'ions à base d'hydrogène s'implantant dans la portion 168 de la couche à base de nitrure 452 au fond de l'ouverture 352. Ces ions à base d'hydrogène proviennent en particulier de la dissociation de la molécule CxHy. Ces ions à base d'hydrogène sont pris parmi : H, H+, H2+, H3+. Dans la suite de la description, et pas souci de concision, on désignera les ions à base d'hydrogène « ions hydrogène ».

De plus, le bombardement d'ions plus lourds que l'hydrogène, désignés ci-dessous « ions lourds » par souci de concision, permet aux espèces chimiques du plasma contenant du carbone provenant du CxHy de former le film carboné 271 sur les flancs de la couche isolante 442, tout en empêchant la formation de ce film carboné 271 dans le fond de l'ouverture 352. Ainsi, l'une au moins des espèces du plasma a pour fonction d'empêcher le dépôt du film carboné 271 sur les parois perpendiculaires à la direction privilégiée de l'implantation. Cette espèce du plasma pulvérise le film carboné qui aurait tendance à se former sur ces parois perpendiculaires à la direction d'implantation typiquement, la face supérieure de la couche à base de nitrure 452 mise à nu à l'étape 410.

On notera que si le masque dur 311 comprend du carbone, alors le bombardement par les ions lourds ne détruit pas le masque dur 311. En effet, en raison des affinités chimiques entre le matériau du masque dur 311 comprenant du carbone et le carbone du plasma, ce dernier ce dépose sur le masque dur 311 rapidement et avant d'être pulvérisé. Ces affinités chimiques permettent d'atteindre un régime de dépôt rapidement et le masque dur 311 n'est ainsi pas consommé.

Ainsi, les espèces du plasma remplissent trois fonctions au moins. Ces trois fonctions seront expliquées en détail dans la description ci-dessous.
« a » dépôt d'une couche protectrice formée du film carboné 271, sur les flancs de l'ouverture 352 ;
« b » empêcher la formation du film carboné 271 dans le fond de l'ouverture 352 ;
« c » modification de la couche à base de nitrure 452 mise à nu dans le fond des ouvertures 352.

Le plasma utilisé dans l'étape de modification 530 comprend de préférence du méthane (CH4) afin de réaliser les fonctions « a » et « c ». Les espèces chimiques du plasma contenant du carbone provenant du CH4 ou plus généralement du CxHy assure la fonction « a ». Pour remplir les fonctions « b », le plasma comprend des ions plus lourds que l'hydrogène tels que l'hélium (He), l'argon (Ar), l'azote (N2), le xénon (Xe) et l'oxygène (02).

La fonction « c » est assurée par les ions à base d'hydrogène, typiquement l'ion hydrogène (H). Ces ions ont pour propriété de pénétrer facilement et en profondeur dans la couche à base de nitrure 452. Ils modifient ainsi la couche à base de nitrure 452 mais sans la pulvériser. Les ions lourds pénètrent beaucoup moins profondément dans la couche à base de nitrure. Ces ions lourds restent localisés en surface et ne sont donc pas aptes à modifier une épaisseur importante, et a fortiori toute l'épaisseur, de la couche à base de nitrure 452. La profondeur de pénétration des ions lourds est environs dix fois plus faible que la profondeur de pénétration des ions hydrogène

Plus précisément, les ions à base d'hydrogène peuvent être implantés dans le matériau à graver, sans provoquer de dislocation de sa structure atomique telle qu'elle entraînerait une pulvérisation de ce dernier, et donc sans redépôt du matériau gravé sur les parois du réacteur ou les motifs en cours de gravure eux-mêmes, sont susceptibles de convenir.

Une fonction additionnelle est assurée par les ions lourds. Cette fonction additionnelle consiste à dissocier la molécule CxHy afin de libérer l'espèce H. L'hélium (He) est particulièrement efficace pour assurer cette fonction. Le mélange introduit dans le réacteur plasma comprend ainsi de préférence un mélange CxHy/He.

On notera ici que cette étape de modification 530 de la portion 168 de la couche à base de nitrure 452 à graver peut se pratiquer de nombreuses façons différentes en adaptant toutes sortes de moyens couramment employés par l'industrie de la microélectronique. On utilise notamment des graveurs standard dont lesquels on peut développer des plasmas à faible ou haute densité et où on peut contrôler l'énergie des ions pour permettre l'implantation des espèces légères ci-dessus destinées à modifier la portion 168 de la couche à base de nitrure 452 à graver. On peut aussi utiliser un type de plasma dit par immersion couramment utilisé pour pratiquer une implantation d'espèces en surface d'un dispositif en cours de fabrication.

L'étape de modification 530 effectuée par une implantation à l'aide d'un plasma a pour avantage de permettre une implantation en continue depuis la surface libre de la couche à base de nitrure 452 et sur une épaisseur faible, typiquement comprise entre 0 et 100 nm voire entre 0 et 30 nm. Elle permet également de bénéficier d'une sélectivité améliorée dès le début de la gravure et d'une vitesse de gravure constante, conduisant à une précision de gravure améliorée, ce qui permet de retirer toute la portion modifié 168 à base de nitrure sans détériorer la couche sous-jacente de siliciure 441.

L'emploi d'un plasma pour implanter la couche à base de nitrure 452 permet ainsi de retirer une couche très fine à base de nitrure, typiquement comprise entre 1 et 10 nm et plus généralement entre 1 et 30 nm.

Cette étape de modification 530 est réalisée pour que le plasma soit anisotrope de manière à bombarder les ions à base d'hydrogène dans une direction 451 privilégiée parallèle aux flancs de la couche isolante 442 et du masque dur 311 définissant l'ouverture 352. Ainsi les ions modifient les surfaces perpendiculaires à la direction du bombardement sur une épaisseur beaucoup plus importante que les surfaces parallèles à la direction 451 du bombardement. Ainsi, les ions à base d'hydrogène du plasma pénètrent seulement dans la portion 168 de la couche à base de nitrure 452 qui est située au droit de l'ouverture 352. Le reste de la couche à base de nitrure 452 qui n'est pas en contact avec le plasma utilisé n'est donc pas modifié.

Ainsi les ions à base d'hydrogène du plasma pénètrent dans la portion 168 pour la modifier. Dans le même temps le CxHy, de préférence du CH4, du plasma tend à déposer un film carboné 271 sur les flancs de la couche isolante 442 et du masque dur 311 définissant l'ouverture 352. Ce film carboné 271 agit ainsi comme une couche de protection pour la couche isolante 442 lors de l'étape de modification 530 de la couche à base de nitrure 452 ainsi que lors de l'étape de retrait 540 de la portion modifiée 168 à base de nitrure (illustrée ultérieurement). Ainsi, le film carboné 271 empêche ou réduit la modification ou/et la dégradation de la couche isolante 442 sous l'effet du bombardement ionique. Il permet de protéger les flancs de la couche isolante 442 de l'attaque de l'acide fluorhydrique (HF) lors de l'étape de retrait 540. Les dimensions de la couche isolante 442 sont donc conservées malgré le bombardement ionique. Le carbone assure ainsi la fonction « a » mentionnée ci-dessus.

Le bombardement d'ions lourds empêche la formation du film carboné 271 sur les surfaces qui sont perpendiculaires à la direction 451 du bombardement, tel que sur la portion modifiée 168 à base de nitrure dans le fond de l'ouverture 352. En effet, le bombardement des ions sur ses surfaces empêchent la croissance de ce film carboné 271. Ces ions assurent ainsi la fonction « b » mentionnée ci-dessus.

En revanche, sur les surfaces qui reçoivent un bombardement moindre ou qui ne reçoivent pas de bombardement, ce film carboné 271 se forme. Ainsi, ce film carboné 271 se forme notamment sur les surfaces parallèles à la direction 451 du bombardement, par exemple au niveau des flancs de la couche isolante 442 et du masque dur 311.

De préférence, toute l'épaisseur de la portion 168 de la couche à base de nitrure 452 au droit de l'ouverture 352 est modifiée. Il ne subsiste ainsi pas de nitrure non modifié recouvrant la couche de siliciure 441 au droit de l'ouverture 352. Ces ions, qui modifient la couche à base de nitrure 452 là où elle est mise à nu, assurent ainsi la formation mentionnée ci-dessus.

Dans un mode de réalisation utilisant un plasma de He/CH4 de préférence sous forme de mélange, la couche à base de nitrure 452 est modifiée par les ions à base d'hydrogène venant du gaz de CH4 (qui diffusent plus profondément que les ions lourds du plasma). Les ions He détruisent ou empêchent la formation du film carboné 271 qui aurait tendance à se former sur les surfaces perpendiculaires à la direction 451 telles que la surface de la portion modifiée 168 à base de nitrure au droit de l'ouverture 352.

Dans un autre mode de réalisation utilisant un plasma de H2/CH4/Ar et/ou N2 et/ou He et/ou Xe et/ou 02, en plus des ions hydrogène, la nature des ions lourds Argon, He, N2, Xe ou 02 et les paramètres du plasma, en particulier son énergie, permettent d'assurer une consommation du film carboné 271 réalisée de manière anisotrope, de sorte que le film carboné 271 n'est pas formé sur les surfaces perpendiculaires à la direction 451 telles que ci-dessus.

Ainsi, les ions lourds Ar, He, N2, Xe ou 02 permettent de renforcer l'action des ions hydrogène en empêchant également la formation du film carboné 271 sur les surfaces perpendiculaires à la direction 451 de bombardement.

On notera que dans tous ces modes de réalisation, les ions H du CH4 participent en synergie avec les ions lourds du plasma (He, Ar, N2, Xe ou 02 par exemple) à la modification de la portion 168 de la couche à base de nitrure 452, même si la profondeur de pénétration de ces ions lourds est plus faible que celle des ions à base d'hydrogène.

Ainsi, à l'issue de cette étape de modification 530, il n'y a pas de dépôt du film carboné 271 sur le fond de l'ouverture 352 grâce au bombardement ionique alors que le film carboné 271 recouvre les surfaces qui sont perpendiculaires ou fortement inclinées par rapport au plan du substrat 140, telles que les flancs de la couche isolante 442 et ceux du masque dur 311.

Le tableau ci-après donne des conditions typiques de mise en oeuvre de l'étape de modification 530 de la couche à base de nitrure 452, réalisé par utilisation d'un plasma de He/CH4 ou d'un plasma H2/CH4/Ar (ou N2, Xe, 02), en fonction du temps en secondes et la puissance de la polarisation (bias) en watts, etc. Ces conditions sont largement dépendantes de l'épaisseur à modifier la portion 168 de la couche à base de nitrure 452 au droit de l'ouverture 352.

| | |
|---|---|
| Réacteur de gravure : | plasma à couplage inductif de He/CH4 |
| | (He : 50 - 500 sccm, CH4 : 5 - 15 sccm), ou plasma de H2/CH4/Ar |
| | (H2 : 50 - 500 sccm, CH4 : 5 - 15 sccm, Ar (Argon) : 100 - 1000 sccm) |
| Épaisseur de la couche à base de nitrure 452 à modifier (épaisseur de la portion modifiée 168 à base de nitrure) : | 1 - à quelques dixièmes de nm |
| Puissance de la source : | 0 - 2000 Watts |
| Puissance de polarisation (énergie des ions) : | 20 - 500 V |
| Pression : | 5 milli Torr - 10 milli Torr |
| Température : | 10 - 100 °C |
| Temps: | quelques secondes à quelques centaines de secondes |

Un exemple plus précis de mise en oeuvre de l'étape de modification 530 permettant de modifier une épaisseur de 17 mm de nitrure, réalisé par utilisation d'un plasma de He/CH4, est décrit dans le tableau ci-dessous:

| | |
|---|---|
| Réacteur de gravure : | plasma de He/CH4 (He : 250 sccm, CH4 : 10 sccm) |
| Épaisseur de la couche à base de nitrure 452 à modifier (épaisseur de la portion modifiée 168 à base de nitrure): | 17 nm |
| Puissance de la source : | 500 W |
| Puissance de polarisation (énergie des ions) : | 250 V |
| Pression : | 10 milli Torr |
| Température : | 60°C |
| Temps : | 60 secondes |

La **figure 2c** illustre le résultat de l'étape de retrait 540 de la portion modifiée 168 à base de nitrure après que l'on ait procédé à une opération de gravure sélective de la portion modifiée 168 à base de nitrure par rapport : au film carboné 271, à des portions non-modifiée de la couche à base de nitrure 452 et à la couche de siliciure 441.

Pour le retrait 540 de la portion modifiée 168 à base de nitrure, on a de préférence recourt à une gravure humide ou à un nettoyage humide (traduction de l'anglais « wet clean »). Les paramètres du nettoyage humide sont réglés de manière à ce que la portion modifiée 168 à base de nitrure puisse être gravée très sélectivement par rapport au film carboné 271 recouvrant notamment des flancs de la couche isolante 442, aux portions non-modifiées de la couche à base de nitrure 452 et à la couche de siliciure 441.

Dans un mode de réalisation préférentiel, l'étape de retrait 540 est effectuée par gravure humide en utilisant une solution à base d'acide fluorhydrique (HF) ou d'acide phosphorique (H3PO4).

La gravure de l'étape 540 est de préférence réalisée par l'utilisation d'une solution d'acide fluorhydrique. La proportion de fluor est alors inférieure à 15% et de préférence inférieure à 10% et de préférence d'environ 5%.

Elle ne forme alors pas ou forme beaucoup moins de cristaux avec le siliciure de la couche de siliciure 441 qu'une solution fluorocarbonée (FC), tel que de type CF4 ou de type C4F8, dont la proportion de fluor est d'environ 20%.

La solution de gravure grave ainsi ladite portion modifiée 168 à laquelle elle a directement accès sur la surface supérieure de la couche de siliciure 441 au fond de l'ouverture 352.

Comme mentionné précédemment, le film carboné 271 permet de protéger les flancs de la couche isolante 442 de l'attaque de l'acide fluorhydrique (HF) lors de l'étape de retrait 540 de la portion modifiée 168. Le masque dur 311 protège la face supérieure de la couche isolante 442.

Les dimensions de la couche isolante 442 sont donc conservées malgré le bombardement ionique.

De plus, la solution de gravure ne consomme avantageusement pas le masque dur 311 comprenant du carbone. La réalisation de l'étape de retrait 540 ne conduit donc pas à une consommation du masque dur 311 comprenant du carbone.

Avantageusement, les paramètres de l'étape de retrait 540 sont également réglés de manière à ce que la portion modifiée 168 à base de nitrure puisse être gravée sélectivement par rapport à la couche de siliciure 441 sous-jacente de préférence de NiPtSi.

Comme mentionné ci-dessus, l'épaisseur de la portion modifiée 168 à base de nitrure est typiquement comprise dans une gamme de valeurs allant de 1 nm à quelques dizaines de nm. Les temps de gravure peuvent aller de quelques secondes à quelques minutes en étant évidemment directement dépendants de l'épaisseur qui a été modifiée.

À titre d'exemple, pour enlever une épaisseur comprise entre 10 nm et 20 nm de nitrure modifié il faut de l'ordre de 30 secondes avec une solution d'acide fluorhydrique (HF) dont le fluor est dilué à 1%. Le même temps de gravure est obtenu avec de l'acide phosphorique dilué (H3PO4) à 85%.

L'arrêt de ladite gravure sélective peut donc se faire sur la couche de siliciure 441 au droit de l'ouverture 352, sans consommation du siliciure de la couche de siliciure 441 et des portions non-modifiées de la couche à base de nitrure 452, jusqu'à la disparition de la portion modifiée 168 à base de nitrure au droit de l'ouverture 352.

Pour l'étape 540 de retrait, alternativement à une gravure humide, on pourra pratiquer une gravure par voie sèche de la portion modifiée 168 à base de nitrure sélectivement aux portions non-modifiées de la couche à base de nitrure 452, au carbone du film carboné 271 et au siliciure de la couche siliciure 441.

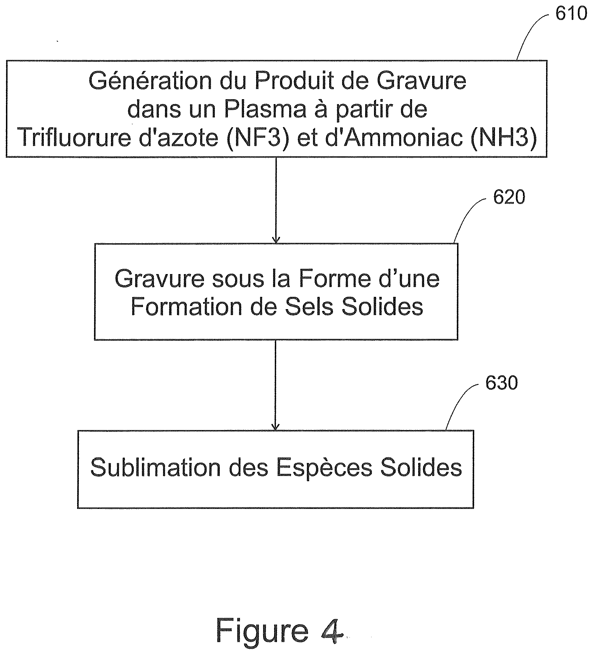

Le principe du retrait par voie sèche de la portion modifiée 168 à base de nitrure comprend les étapes suivantes 610 à 630 illustrées en figure 4 qui s'effectuent dans une chambre de réaction où l'on forme un plasma. Les épaisseurs traitées sont typiquement comprises entre 1 nm et quelques dizaines de nanomètres.

La méthode est celle décrite par H. Nishini et ses coauteurs dans une publication en anglais intitulée « Damage-free selective etching of Si native oxides using NH3/NF3 and SF6/H2O down flow etching » parue dans le « Journal of Applied Physics » volume 74 (2), en juillet 1993. Le principe du retrait par voie sèche de la portion modifiée 168 est proche de celui décrit dans la publication ci-dessus. La différence est que dans le cas de l'invention on ne grave pas de l'oxyde de silicium mais la portion modifiée 168 par utilisation d'un plasma de type par exemple H2/CH4/Ar.

Le mécanisme est toutefois le même et comprend les étapes suivantes qui s'effectuent dans une chambre de réaction où l'on forme un plasma. Une première étape 610 consiste à générer le produit de gravure dans le plasma selon la réaction chimique suivante :

NF₃+NH₃ → NH₄F + NH₄F.HF

qui fait réagir du trifluorure d'azote (NF₃) avec de l'ammoniac (NH₃).

La gravure se fait au cours d'une deuxième étape 620, à une température de l'ordre de 30°C et plus généralement entre 10°C et 50°C, sous la forme d'une formation de sels selon la réaction chimique suivante :

NH₄F or NH₄F.HF + SiNH → (NH₄)2SiF₆ (solide) + H₂

au cours d'une opération qui dure entre quelques secondes et quelques minutes et qui s'effectue sous une pression comprise entre quelques milli Torr et quelques Torr. Plus précisément, cette opération dure entre 20 secondes et 2 minutes et s'effectue sous une pression comprise entre 500 milli Torr et 3 Torrs.

Les espèces solides qui sont formées au cours de cette opération sont ensuite sublimées 630 à une température supérieure à 100°C pendant quelques dizaines de secondes selon la réaction suivante :

(NH₄)2SiF₆ (solid) → SiF₄(g) + NH₃(g) + HF(g)

Par exemple, pour enlever une couche de 10 nm de nitrure modifié les flux de trifluorure d'azote (NF₃) et d'ammoniac (NH₃) sont respectivement de 50 sccm et de 300 sccm à 30°C pendant 45 secondes pour l'étape 620 de formation des sels qui est suivie par l'étape de sublimation 630 qui s'effectue à 180°C pendant 60 secondes.

Ce mode de réalisation permet d'obtenir une très bonne sélectivité de la gravure du nitrure modifié par rapport au nitrure non modifié, au carbone du film carboné 271 et au siliciure de la couche de siliciure 441. En particulier, cette sélectivité de la gravure est très supérieure (typiquement un facteur 10 au moins) à celle obtenue avec une solution de HF.

La **figure 2f** illustre la structure finale de l'ouverture 352 obtenue à l'issue de l'étape de retrait 450 du masque dur 311.

L'étape de retrait 450 du masque dur 311 est effectuée par gravure sélective du carbone du masque dur 311 par rapport à l'oxyde de la couche isolante 442, à la couche à base de nitrure 452 et à la couche de siliciure 441.

Selon le présent mode de réalisation, cette étape de retrait 450 du masque dur 311 est réalisée après l'étape de retrait 540 de la portion modifiée 168 à base de nitrure. La gravure est réalisée de préférence dans un plasma avec une chimie oxydante de type N2/O2 pour consommer également le film carboné 271 sur les flancs de la couche isolante 442.

Néanmoins, dans un autre mode de réalisation (illustré ultérieurement en **figures 2a, 2b****,** **2d** **et** **2e**), le film carboné 271 sur les flancs de la couche isolante 442 est conservé lors de l'étape de retrait 450 du masque dur 311. Cette variante sera détaillée ci-dessous.

Suite à l'étape d'obtention de la structure illustrée en **figure 2f****,** on peut procéder aux étapes conventionnelles de finition des interconnexions. Par exemple, on peut remplir l'ouverture 352 d'un matériau électriquement conducteur.

Un autre mode de réalisation de formation de trous de contact 352 pour le transistor 200 est illustré en **figures 2a, 2b****,** **2d** et **2e****.**

L'étape d'ouverture 410 de l'ouverture 352 du présent mode de réalisation n'est pas différente de celle illustrée précédemment en référence au mode de réalisation décrit en **figures 2a** à **2c** et **2f.** Le présent mode de réalisation diffère de celui décrit dans le mode de réalisation décrit en **figures 2a** à **2c** et **2f** en ce que l'étape de retrait 420 comprend : l'étape de modification 530 de la couche à base de nitrure 452 au droit de l'ouverture 352 puis une étape de retrait 450 du masque dur 311 puis une étape de retrait 540 de la portion modifiée 168 à base de nitrure.

L'étape de modification 530 du présent mode de réalisation n'est pas différente de celle illustrée précédemment en référence au mode de réalisation décrit en **figures 2a** à **2c** et **2f.** La **figure 2d** illustre la structure du transistor 200 à l'issue de l'étape de retrait 450 du masque dur 311 selon le présent mode de réalisation. Le mode de réalisation est une alternative à celui illustré en référence aux **figures 2c** **et** **2f****.** Il est donc représenté en pointillés sur la **figure 3****.**

Cette étape de retrait 450 du masque dur 311 est effectuée, après l'étape de modification 530 et avant l'étape de retrait 540 de la portion modifiée 168 à base de nitrure, par gravure sélective du masque dur 311 par rapport à la portion modifiée 168 à base de nitrure et au carbone du film carboné 271 sur les flancs de la couche isolante 442.

Afin de ne pas consommer le carbone du film carboné 271 au niveau des flancs de la couche isolante 442 tout en retirant le masque dur 311, la gravure est par exemple réalisée dans un plasma avec une chimie réductrice de type N2/H2. La gravure utilisée lors du retrait du masque dur 311 est sélective par rapport à l'oxyde de la couche isolante 442 de manière à ne pas consommer cette couche isolante 442.

La **figure 2e** illustre la structure du transistor 200 à l'issue de l'étape de retrait 540 de la portion modifiée 168 à base de nitrure selon le présent mode de réalisation. Cette étape de retrait 540 est effectuée pour graver la portion modifiée 168 à base de nitrure sélectivement aux portions non-modifiées de la couche à base de nitrure 452, au carbone du film carboné 271 sur les flancs de la couche isolante 442 et au siliciure de la couche de siliciure 441 au fond de l'ouverture 352. Le type de gravure sélective et les conditions de réalisation de mise en oeuvre de cette étape de retrait 540 sont similaires à ceux de l'étape 540 du mode de réalisation illustré précédemment en **figures 2a** à **2c** et **2f.**

Ce mode de réalisation présente pour avantage important que le film carboné 271 protège les flancs de la couche isolante 442 de l'attaque de l'acide fluorhydrique (HF) lors de l'étape de retrait 540. Les dimensions de la couche isolante 442 sont donc conservées. Un autre avantage significatif est que la portion modifié 168 à base de nitrure dans le fond de l'ouverture 352 recouvre et protège la couche sous-jacente de siliciure 441 lors de la gravure du masque dur 311.

A l'issue de l'étape de retrait 540, le film carboné 271 sur les flancs de la couche isolante 442 est d'épaisseur très fine, comprise par exemple entre 1 nm et 2 nm, ce qui n'est pas gênant pour les étapes additionnelles standards. Ce film carboné 271 peut ainsi être conservé.

De la description qui précède, il ressort de nombreux avantages conférés par l'invention. Le procédé de l'invention permet notamment une modification anisotrope réalisée de manière très sélective au carbone, au nitrure non-modifié et au siliciure, ce qui permet de constituer ultérieurement des trous de contact pour le transistor avec une précision significativement améliorée en termes de dimensions et de géométrie.

Le procédé de l'invention s'avère particulièrement avantageuse pour former les trous de contact pour les transistors de type MOSFET ou FinFET.

Le procédé de la présente invention permet de contrôler très précisément la dimension des trous de contact tout en s'affranchissant ou en réduisant les problèmes détaillés précédemment, par exemple : la modification du siliciure de la couche de siliciure ou la formation des cristaux sur la couche de siliciure au fond de trous de contact tel que décrit en **figures 1c** et **1d****.**

L'invention n'est pas limitée aux seuls modes et exemples de réalisation décrits ci-dessus, mais s'étend à tous les modes de réalisation entrant dans la portée des revendications.

Notamment bien que les ouvertures verticales forment généralement des trous, l'invention dans tous ces modes de réalisation s'étend à toutes formes d'ouvertures verticales.

## Revendications

1. Procédé de réalisation d'ouvertures de contact (352) pour la connexion d'un transistor à effet de champ (200) à partir d'un empilement de couches comprenant au moins une couche active (146) en un matériau semi-conducteur, une couche de siliciure (441) surmontant la couche active (146), une couche à base de nitrure (452) surmontant la couche de siliciure (441) et une couche isolante (442) électriquement surmontant la couche à base de nitrure (452), le procédé comprenant les étapes suivantes :
- une étape d'ouverture (410) de la couche isolante (442) pour former dans la couche isolante (442) au moins une ouverture (352) mettant à nu la couche à base de nitrure (452) et délimitée par des flancs de la couche isolante (442) ;
- une étape de retrait (420) de la couche à base de nitrure (452) au droit de l'ouverture (352) de manière à mettre à nu la couche de siliciure (441);
le procédé étant **caractérisé en ce que** l'étape de retrait (420) de la couche à base de nitrure (452) au droit de l'ouverture (352) comprend les étapes suivantes :
- au moins une étape de modification (530) de la couche à base de nitrure (452) au droit de l'ouverture (352) par mise en présence de la couche à base de nitrure (452) avec un plasma dans lequel on introduit du CxHy où x est la proportion de carbone et y est la proportion d'ions hydrogène (H), le plasma comprenant au moins des ions à base d'hydrogène (H, H⁺, H₂⁺, H₃⁺ etc.) provenant notamment du CxHy, des espèces chimiques contenant du carbone provenant du CxHy et des ions plus lourds que l'hydrogène ; les conditions du plasma, en particulier la concentration en CxHy, l'énergie des ions et la direction principale d'implantation étant choisies de manière à ce que :
o au moins une partie des ions à base d'hydrogène provenant du CxHy s'implantent dans une portion (168) de la couche à base de nitrure (452) au droit de l'ouverture (352) et formant ainsi une portion modifiée (168) de la couche à base de nitrure (452);
o au moins une partie des espèces chimiques du plasma contenant du carbone provenant du CxHy forment un film carboné (271) sur lesdits flancs de la couche isolante (442) ;
o les ions plus lourds que l'hydrogène empêchent lesdites espèces chimiques du plasma contenant du carbone de former un film carboné (271) sur le fond de l'ouverture (352),
- au moins une étape de retrait (540) de la portion modifiée (168) de la couche à base de nitrure (452) à l'aide d'une gravure sélective de la portion modifiée (168) à base de nitrure vis-à-vis des portions non-modifiées de la couche à base de nitrure (452) et vis-à-vis au film carboné (271).

2. Procédé selon la revendication 1 dans lequel l'étape de modification (530) est réalisée de manière à ce que le plasma génère un bombardement des ions plus lourds que l'hydrogène de manière anisotrope selon une direction privilégiée parallèle aux flancs de la couche isolante (442) définissant l'ouverture (352), de sorte à empêcher lesdites espèces chimiques du plasma contenant du carbone de former un film carboné (271) sur le fond de l'ouverture (352).

3. Procédé selon l'une quelconque des revendications précédentes dans lequel l'étape de modification (530) est réalisée de manière à ce que les ions plus lourds que l'hydrogène du plasma dissocient la molécule du CxHy de sorte à permettre aux ions hydrogène (H) provenant du CxHy de former des ions à base d'hydrogène et de s'implanter dans ladite portion (168) de la couche à base de nitrure (452).

4. Procédé selon l'une quelconque des revendications précédentes dans lequel l'étape de retrait (540) de la portion modifiée (168) à base de nitrure est effectuée par gravure sélectivement à la couche de siliciure (441).

5. Procédé selon l'une quelconque des revendications précédentes dans lequel lors de l'étape de modification (530) les conditions du plasma, en particulier la concentration en CxHy, l'énergie des ions et la direction principale d'implantation sont choisies de manière à ce que toute l'épaisseur de la couche à base de nitrure (452) soit modifiée par l'implantation des ions à base d'hydrogène provenant notamment du CxHy et dans lequel l'étape de retrait (540) est réalisée de manière à retirer toute l'épaisseur de la couche modifiée (168), mettant ainsi à nu la couche de siliciure (441) au droit des ouvertures (352).

6. Procédé selon l'une quelconque des revendications précédentes dans lequel le CxHy est du CH4.

7. Procédé selon l'une quelconque des revendications précédentes dans lequel les ions plus lourds que l'hydrogène sont pris parmi l'hélium (He), l'argon (Ar), l'azote (N2), le xénon (Xe) et l'oxygène (02).

8. Procédé selon l'une quelconque des revendications précédentes dans lequel la couche à base de nitrure (452) est une couche de nitrure de silicium.

9. Procédé selon l'une quelconque des revendications précédentes dans lequel la couche de siliciure (441) est une couche de NiPtSi et/ou dans lequel la couche isolante (442) est de l'oxyde de silicium.

10. Procédé selon l'une quelconque des revendications précédentes dans lequel l'étape de retrait (540) de la portion modifiée (168) à base de nitrure est effectuée par gravure humide et de préférence dans lequel la gravure est effectuée à l'aide d'une solution à base d'acide fluorhydrique (HF) ou de H3PO4.

11. Procédé selon l'une quelconque des revendications 1 à 9 dans lequel l'étape de retrait (540) est effectuée par gravure par voie sèche sélective à la couche de siliciure (441) et de préférence dans lequel la gravure sèche est effectuée dans un plasma formé dans une enceinte confinée à partir de trifluorure d'azote (NF3) et d'ammoniac (NH3).

12. Procédé selon l'une quelconque des revendications précédentes, dans lequel l'empilement de couches comprend en outre un masque dur (311) surmontant la couche isolante (442).

13. Procédé selon la revendication précédente comprenant, après l'étape de retrait (540) de la portion modifiée (168) à base de nitrure, une étape de retrait (450) du masque dur (311) qui est effectuée par une gravure sélective du masque dur (311) vis-à-vis de la couche isolante (442) et de la couche de siliciure (441).

14. Procédé selon l'une quelconque des deux revendications précédentes comprenant, après l'étape de modification (530) de la couche à base de nitrure (452) et avant l'étape de retrait (540) de la portion modifiée (168) à base de nitrure, une étape de retrait (450) du masque dur (311) qui est effectuée par une gravure sélective du masque dur (311) vis-à-vis au moins : du film carboné (271) recouvrant lesdits flancs de la couche isolante (442) et de la portion modifiée (168) à base de nitrure.

15. Procédé selon l'une quelconque des revendications précédentes, dans lequel le transistor (200) est un transistor de type FDSOI ou un transistor de type FinFET et/ou dans lequel l'ouverture (352) débouche sur la couche de siliciure (441) au niveau de l'un parmi : une grille, une source, un drain du transistor, de manière à former un via d'interconnexion.

## Patentansprüche

1. Verfahren zur Bildung von Kontaktöffnungen (352) für den Anschluss eines Feldeffektransistors (200) aus einer Stapelung von Schichten, umfassend mindestens eine aktive Schicht (146) aus einem Halbleitermaterial, eine Schicht aus Silizid (441), die über der aktiven Schicht (146) angebracht ist, eine Schicht auf Basis von Nitrid (452), die über der Schicht aus Silizid (441) angebracht ist, und eine elektrisch isolierende Schicht (442), die über der Schicht auf Basis von Nitrid (452) angebracht ist, wobei das Verfahren die folgenden Schritte umfasst:
- einen Schritt des Öffnens (410) der Isolierschicht (442), um in der Isolierschicht (442) mindestens eine Öffnung (352) zu bilden, die die Schicht auf Basis von Nitrid (452) freilegt und von den Seiten der Isolierschicht (442) begrenzt ist;
- einen Schritt des Abhebens (420) der Schicht auf Basis von Nitrid (452) im rechten Winkel zu der Öffnung (352), um die Schicht aus Silizid (441) freizulegen;
wobei das Verfahren **dadurch gekennzeichnet ist, dass** der Schritt des Abhebens (420) der Schicht auf Basis von Nitrid (452) im rechten Winkel zu der Öffnung (352) die folgenden Schritte umfasst:
- mindestens einen Schritt der Modifikation (530) der Schicht auf Basis von Nitrid (452) im rechten Winkel zu der Öffnung (352) durch Inkontaktbringen der Schicht auf Basis von Nitrid (452) mit einem Plasma, in das CxHy eingeleitet wird, wobei x der Kohlenstoffanteil und y der Wasserstoffanteil (H) ist, wobei das Plasma mindestens Ionen auf Basis von Wasserstoff (H, H⁺, H₂⁺, H₃⁺, usw.), insbesondere von dem CxHy stammend, und Ionen, die schwerer als der Wasserstoff sind, umfasst; wobei die Bedingungen des Plasmas, insbesondere die Konzentration an CxHy, die Energie der Ionen und die Haupteinsetzrichtung derart gewählt sind, dass:
∘ sich mindestens ein Teil der Ionen auf Basis von Wasserstoff, stammend von dem CxHy, in einen Abschnitt (168) der Schicht auf Basis von Nitrid (452) im rechten Winkel zur Öffnung (352) setzen und so einen modifizierten Abschnitt (168) der Schicht auf Basis von Nitrid (452) bilden;
∘ mindestens ein Teil der chemischen Spezies des Plasmas, die Kohlenstoff enthalten, stammend von dem CxHy, einen Kohlenstofffilm (271) auf den Seiten der Isolierschicht (442) bilden;
∘ die Ionen, die schwerer sind als der Wasserstoff die chemischen Spezies des Plasmas, die Kohlenstoff enthalten, daran hindern, einen Kohlenstofffilm (271) am Boden der Öffnung (352) zu bilden,
- mindestens einen Schritt des Abhebens (540) des modifizierten Abschnitts (168) auf Basis von Nitrid (452) mit Hilfe einer selektiven Gravur des modifizierten Abschnitts (168) auf Basis von Nitrid gegenüber den nicht modifizierten Abschnitten der Schicht auf Basis von Nitrid (452) und gegenüber dem Kohlenstofffilm (271).

2. Verfahren nach Anspruch 1, bei dem der Modifikationsschritt (530) derart erfolgt, dass das Plasma einen Beschuss der Ionen, die schwerer sind als der Wasserstoff, auf anisotrope Weise entlang einer bevorzugten Richtung parallel zu den Seiten der Isolierschicht (442), die die Öffnung (352) definieren, erzeugt, um die chemischen Spezies des Plasmas, die Kohlenstoff enthalten, daran zu hindern, einen Kohlenstofffilm (271) am Boden der Öffnung (352) zu bilden.

3. Verfahren nach einem der vorhergehenden Ansprüche, bei dem der Modifikationsschritt (530) derart erfolgt, dass die Ionen, die schwerer sind als der Wasserstoff, des Plasmas das Molekül des CxHy abtrennen, um es den Wasserstoffionen (H), die von dem CxHy stammen, zu ermöglichen, Ionen auf Basis von Wasserstoff zu bilden und sich in den Abschnitt (168) der Schicht auf Basis von Nitrid (452) zu setzen.

4. Verfahren nach einem der vorhergehenden Ansprüche, bei dem der Schritt des Abhebens (540) des modifizierten Abschnitts (168) auf Basis von Nitrid durch Gravur selektiv an der Silizidschicht (441) durchgeführt wird.

5. Verfahren nach einem der vorhergehenden Ansprüche, bei dem bei dem Modifikationsschritt (530) die Bedingungen des Plasmas, insbesondere die Konzentration an CxHy, die Energie der Ionen und die Haupteinsetzrichtung derart gewählt sind, dass die gesamte Dicke der Schicht auf Basis von Nitrid (452) durch das Einsetzen der Ionen auf Basis von Wasserstoff, insbesondere vom CxHy stammend, modifiziert wird, und bei dem der Schritt des Abhebens (540) derart erfolgt, dass die gesamte Dicke der modifizierten Schicht (168) abgehoben wird, wodurch die Silizidschicht (441) im Bereich der Öffnungen (352) freigelegt wird.

6. Verfahren nach einem der vorhergehenden Ansprüche, bei dem das CxHy CH4 ist.

7. Verfahren nach einem der vorhergehenden Ansprüche, bei dem die Ionen, die schwerer sind als der Wasserstoff, unter Helium (He), Argon (Ar), Stickstoff (N2), Xenon (Xe) und Sauerstoff (02) ausgewählt sind.

8. Verfahren nach einem der vorhergehenden Ansprüche, bei dem die Schicht auf Basis von Nitrid (452) eine Schicht von Siliziumnitrid ist.

9. Verfahren nach einem der vorhergehenden Ansprüche, bei dem die Silizidschicht (441) eine Schicht aus NiPtSi und/oder bei dem die Isolierschicht (442) Siliziumoxid ist.

10. Verfahren nach einem der vorhergehenden Ansprüche, bei dem der Schritt des Abhebens (540) der modifizierten Schicht (168) auf Basis von Nitrid durch Feuchtgravur erfolgt, und bei dem die Gravur mit Hilfe einer Lösung auf Basis von Fluorwasserstoffsäure (HF) oder von H3PO4 erhalten wird.

11. Verfahren nach einem der Ansprüche 1 bis 9, bei dem der Schritt des Abhebens (540) durch selektive Trockengravur der Silizidschicht (441) erfolgt, und bei dem vorzugsweise die Trockengravur in einem Plasma erfolgt, das in einem eingegrenzten Bereich aus Stickstoff- (NF3) und Ammoniak-Trifluorid (NH3) gebildet ist.

12. Verfahren nach einem der vorhergehenden Ansprüche, bei dem die Stapelung von Schichten ferner eine harte Maske (311) umfasst, die über der Isolierschicht (442) montiert ist.

13. Verfahren nach dem vorhergehenden Anspruch, umfassend nach dem Schritt des Abhebens (540) des modifizierten Abschnitts (168) auf Basis von Nitrid einen Schritt des Abhebens (450) der harten Maske (311), der durch eine selektive Gravur der harten Maske (311) gegenüber der Isolierschicht (442) und der Silizidschicht (441) erfolgt.

14. Verfahren nach einem der beiden vorhergehenden Ansprüche, umfassend nach dem Schritt (530) der Modifikation der Schicht auf Basis von Nitrid (452) und vor dem Schritt des Abhebens (540) des modifizierten Abschnitts (168) auf Basis von Nitrid einen Schritt des Abhebens (450) der harten Maske (311), der durch eine selektive Gravur der harten Maske (311) gegenüber mindestens: einem Kohlenstofffilm (271), der die Seiten der Isolierschicht (442) bedeckt, und dem modifizierten Abschnitt (168) auf Basis von Nitrid erfolgt.

15. Verfahren nach einem der vorhergehenden Ansprüche, bei dem der Transistor (200) ein Transistor vom Typ FDSOI oder ein Transistor vom Typ FinFET ist, und/oder bei dem die Öffnung (352) auf der Silizidschicht (441) im Bereich eines unter: Gate, Source, Drain des Transistors mündet, um einen Zusammenschluss zu bilden.

## Claims

1. A method for making contact openings (352) for connecting a field effect transistor (200) from a stack of layers comprising at least an active layer (146) made of a semi-conductor material, a silicide layer (441) on the top of the active layer (146), a nitride-based layer (452) on the top of the silicide layer (441) and an electrically insulating layer (442) on the top of the nitride-based layer (452), the method comprising the following steps:
- a step of opening (410) the insulating layer (442) for forming in the insulating layer (442) at least an opening (352) exposing the nitride-based layer (452) and delimited by flanks of the insulating layer (442);
- a step of removing (420) the nitride-based layer (452) at the opening (352) so as to expose the silicide layer (441);
with the method **being characterized in that** the step of removing (420) the nitride-based layer (452) at the opening (352) comprises the following steps:
- at least a step of modifying (530) the nitride-based layer (452) at the opening (352) by putting in contact the nitride-based layer (452) with a plasma wherein CxHy is introduced where x is the proportion of carbon and y is the proportion of hydrogen ions (H), with the plasma comprising at least hydrogen-based ions (H, H⁺, H₂⁺, H₃⁺ etc.) more particularly provided by CxHy, chemical species containing carbon provided by CxHy and ions heavier than hydrogen; the conditions of plasma, more particularly the concentration of CxHy, the ion energy and the main implantation direction being so chosen that:
o at least a part of hydrogen-based ions provided by CxHy are implanted in a portion (168) of the nitride-based layer (452) at the opening (352) and thus forming a modified portion (168) of the nitride-based layer (452);
o at least a part of the plasma chemical species containing carbon provided by CxHy form a carbon film (271) on said flanks of the insulating layer (442);
o the ions heavier than hydrogen prevent said carbon-containing plasma chemical species from forming a carbon film (271) at the bottom of the opening (352),
- at least a step of removing (540) the modified portion (168) of the nitride-based layer (452) using a selective etching of the nitride-based modified portion (168) relative to non-modified portions of the nitride-based layer (452) and relative to the carbon film (271).

2. A method according to claim 1, wherein the step of modifying (530) is so executed that the plasma generates an anisotropic bombardment with ions heavier than hydrogen according to a favorite direction parallel to the flanks of the insulating layer (442) defining the opening (352), so as to prevent said carbon-containing plasma chemical species from forming a carbon film (271) at the bottom of the opening (352).

3. A method according to any one of the preceding claims, wherein the step of modifying (530) is so executed that the ions heavier than hydrogen of plasma dissociate the CxHy molecule so as to enable the hydrogen ions (H) provided by CxHy to form hydrogen-based ions and to implant them into said portion (168) of the nitride-based layer (452).

4. A method according to any one of the preceding claims, wherein the step of removing (540) the nitride-based modified portion (168) is executed using selective etching of the silicide layer (441).

5. A method according to any one of the preceding claims, wherein during the step of modifying (530) the conditions of plasma, more particularly the concentration of CxHy, the ion energy and the main implantation direction are so selected that the whole thickness of the nitride-based layer (452) is modified by the implantation of hydrogen-based ions more particularly provided by CxHy and wherein the step of removing (540) is so executed as to remove the whole thickness of the modified layer (168), thus exposing the silicide layer (441) at the openings (352).

6. A method according to any one of the preceding claims, wherein CxHy is CH4.

7. A method according to any one of the preceding claims, wherein the ions heavier than hydrogen are selected among helium (He), argon (Ar), nitrogen (N2), xenon (Xe) and oxygen (02).

8. A method according to any one of the preceding claims, wherein the nitride-based layer (452) is a silicon nitride layer.

9. A method according to any one of the preceding claims, wherein the silicide layer (441) is a NiPtSi layer and/or wherein the insulating layer (442) is made of silicon oxide.

10. A method according to any one of the preceding claims, wherein the step of removing (540) the nitride-based modified portion (168) is executed using wet etching and preferably, wherein etching is executed using a based solution hydrofluoric acid (HF) or H3PO4.

11. A method according to any one of claims 1 to 9, wherein the step of removing (540) is executed by dry etching selectively to the silicide layer (441) and preferably wherein dry etching is executed in plasma formed in a confined enclosure from nitrogen trifluoride (NF3) and ammonia (NH3).

12. A method according to any one of the preceding claims, wherein the stack of layers further comprises a hard mask (311) on the top of the insulating layer (442).

13. A method according to the preceding claim, comprising, after the step of removing (540) the nitride-based modified portion (168), a step of removing (450) the hard mask (311) which is executed by selective etching of the hard mask (311) relative to the insulating layer (442) and the silicide layer (441).

14. A method according to any one of the two preceding claims comprising, after the step of modifying (530) the nitride-based layer (452) and prior to the step of removing (540) the nitride-based modified portion (168), a step of removing (450) the hard mask (311) which is executed by a selective etching of the hard mask (311) relative to at least: the carbon film (271) covering said flanks of the insulating layer (442) and of the nitride-based modified portion (168).

15. A method according to any one of the preceding claims, wherein the transistor (200) is a transistor of the FDSOI type or a transistor of the FinFET type and/or wherein the opening (352) leads to the silicide layer (441) at the level of one among: a gate, a source, a drain of the transistor, so as to form an interconnecting via.
